(19) Europäisches Patentamt
European Patent Office
Office européen des brevets

(11) **EP 3 540 769 B1**

(12) **FASCICULE DE BREVET EUROPEEN**

(45) Date de publication et mention
de la délivrance du brevet:
**09.12.2020 Bulletin 2020/50**

(51) Int Cl.:
*H01L 25/065* *(2006.01)*    *H01L 23/485* *(2006.01)*
*H01L 23/528* *(2006.01)*    *H01L 23/525* *(2006.01)*

(21) Numéro de dépôt: **19161512.9**

(22) Date de dépôt: **08.03.2019**

(54) **EMPILEMENT 3D DE PUCES ÉLECTRONIQUES**

3D-STAPELUNG VON ELEKTRONISCHEN CHIPS

3D STACK OF ELECTRONIC CHIPS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **12.03.2018 FR 1852110**

(43) Date de publication de la demande:
**18.09.2019 Bulletin 2019/38**

(73) Titulaire: **Commissariat à l'Energie Atomique et
aux Energies
Alternatives
75015 Paris (FR)**

(72) Inventeur: **LATTARD, Didier
38054 Grenoble cedex 09 (FR)**

(74) Mandataire: **Lebkiri, Alexandre
Cabinet Camus Lebkiri
25, Rue de Maubeuge
75009 Paris (FR)**

(56) Documents cités:
**FR-A1- 2 828 334        US-A1- 2008 156 521
US-A1- 2014 252 606       US-A1- 2015 008 575**

• **JANI IMED ET AL: "Innovative structures to test
bonding alignment and characterize high density
interconnects in 3D-IC", 2017 15TH IEEE
INTERNATIONAL NEW CIRCUITS AND SYSTEMS
CONFERENCE (NEWCAS), IEEE, 25 juin 2017
(2017-06-25), pages 153-156, XP033141924, DOI:
10.1109/NEWCAS.2017.8010128**

**Description**

**DOMAINE TECHNIQUE**

La présente invention est relative aux circuits intégrés en trois dimensions (3D IC) et concerne plus particulièrement un empilement 3D de puces électroniques qui tolère un désalignement important entre deux puces électroniques superposées.

**ÉTAT DE LA TECHNIQUE**

L'intégration tridimensionnelle (3D) consiste à empiler plusieurs puces électroniques (aussi appelées circuits intégrés) et à les relier électriquement entre elles, par exemple par une technique de collage. Cette approche permet notamment de réduire l'encombrement des systèmes dits « hétérogènes » qui sont composés de circuits appartenant à des technologies différentes, par exemple un capteur d'image comprenant une matrice de photodiodes et un circuit CMOS de traitement d'image comprenant des transistors. L'intégration 3D permet également d'augmenter la densité de transistors par unité de surface sans réduire leurs dimensions et de diminuer la consommation électrique d'un système, en remplaçant de longues interconnexions horizontales par de courtes interconnexions verticales.

Un circuit 3D peut adopter plusieurs architectures en fonction notamment de la manière dont sont empilées les puces, de l'orientation des puces et du type de collage.

L'empilement peut être réalisé selon différentes approches : de plaque à plaque (pour « wafer-to-wafer » en anglais), de puce à plaque (« die-to-wafer ») ou encore de puce à puce (« die-to-die »). La technique d'empilement plaque à plaque est la plus rapide en nombre de puces collées par heure, car il s'agit d'un collage collectif à l'échelle des plaques de silicium. Elle est également la plus précise pour une vitesse de collage donnée. Par contre, à la différence des deux autres techniques, elle n'offre pas la possibilité de n'assembler que les puces fonctionnelles (dites « Know Good Dies »), sélectionnées après une série de tests et la découpe des plaques. Le rendement après assemblage obtenu par la technique plaque à plaque est donc inférieur au rendement de la technique puce à plaque et au rendement de la technique puce à puce. Cette dernière technique est naturellement la plus longue à mettre œuvre, car les puces sont collées entre elles deux par deux après la découpe des plaques.

Lorsque les puces (ou les plaques) sont orientées dans le même sens, la face avant d'une puce est collée à la face arrière d'une autre puce. Ce mode d'assemblage est appelé « back-to-face ». Inversement, lorsque les puces (ou les plaques) sont assemblées après retournement de l'une d'entre elles, les puces sont collées face avant contre face avant (« face-to-face ») ou face arrière contre face arrière (« back-to-back »).

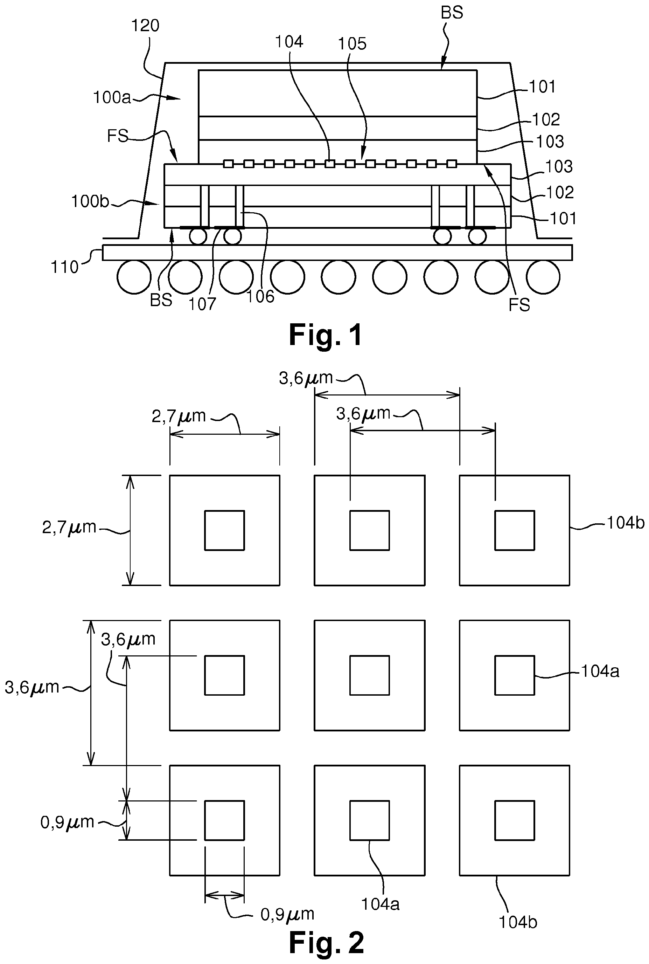

La figure 1 illustre un exemple de circuit 3D intégrant une première puce 100a et une deuxième 100b dans un boîtier (ici BGA) composé d'un substrat 110 et d'un capot 120. La première puce 100a, dite puce supérieure, est empilée sur la deuxième puce 100b, appelée puce inférieure. Chaque puce comprend, de la face arrière BS à la face avant FS, un substrat en silicium 101, un premier bloc fonctionnel 102 (ou ensemble de niveaux technologiques) appelé FEOL (« Front End Of Line ») qui regroupe les composants actifs (ex. transistors) de la puce, et un deuxième bloc fonctionnel 103 appelé BEOL (« Back End Of Line ») qui regroupe les composants passifs (ex. résistances, inductances, capacités) et les interconnexions de la puce. Les interconnexions du bloc BEOL 103 sont typiquement réparties en plusieurs niveaux de métal.

Les puces 100a-100b sont dans cet exemple assemblées face avant contre face avant (« face-to-face ») par une technique de collage direct de type hybride. Chaque puce présente en face avant FS une surface de collage composée de plots d'interconnexion 104 en métal et de portions isolantes 105, typiquement en oxyde de silicium. Les portions isolantes 105 séparent les plots d'interconnexion 104. Les plots d'interconnexion 104 de la première puce 100a sont en contact direct avec les plots d'interconnexion 104 de la deuxième puce 100b, de façon à coupler électriquement les deux puces 100a-100b. Les plots d'interconnexion, typiquement en cuivre, participent au collage des deux puces et acheminent des signaux électriques d'une puce à l'autre. Les plots d'interconnexion 104 en face avant FS de chaque puce sont généralement organisés en lignes et en colonnes, sous la forme d'une matrice ou maille. L'ensemble des plots d'interconnexion 104 appartenant aux deux puces 100a-100b constitue une structure dite d'interconnexion 3D.

Des vias traversants 106 désignés par l'acronyme TSV de l'anglais « Through Silicon Via » s'étendent en outre à travers la puce inférieure 100b, et plus particulièrement du premier niveau de métal du bloc BEOL jusqu'à la face arrière BS. Ces vias traversants 106 servent à acheminer les signaux électriques depuis la face avant FS de la puce 100b jusqu'à sa face arrière BS. Le substrat 101 de la puce inférieure 100b est aminci spécialement pour permettre la réalisation de ces vias.

Les signaux sont ensuite répartis (ou redistribués) sur la face arrière BS de la puce inférieure 100b, à l'aide d'une couche de redistribution 107 dite RDL (« redistribution layer »). Le rôle de cette couche RDL 107 est de relier électriquement chacun des TSV 106 à une zone de reprise de contact, à partir de laquelle les signaux sont acheminés vers l'extérieur du boîtier protégeant les puces.

Une technique d'assemblage connue consiste à adopter la même géométrie pour la matrice de plots d'interconnexion 104 de la première puce 100a et la matrice de plots d'interconnexion 104 de la deuxième puce 100b. Les plots d'interconnexion 104 des puces 100a-100b sont alors de même forme, par exemple de section carrée (dans le plan de la face avant FS), de mêmes dimensions et espacés de la même distance. Avec une telle structure d'interconnexion 3D, le moindre désalignement lors du collage des deux puces se traduit par une diminution de la surface de contact entre les plots d'interconnexion 104. Or une diminution de la surface de contact est préjudiciable pour la qualité de collage, notamment d'un point de vue mécanique, et pour les performances électriques de l'empilement. Comme le désalignement a tendance à varier d'un empilement de puces à l'autre (même lorsque les puces inférieures/supérieures appartiennent à une même plaque, i.e. approche puce-à-plaque ou plaque à plaque), une dispersion liée au désalignement apparaît dans les performances des circuits 3D.

Le document [« Ultra-fine Pitch 3D Intégration Using Face-to-Face Hybrid Wafer Bonding Combined with a Via-Middle Through-Silicon-Via Process », SW. Kim et al., Electronic Components and Technology Conférence (ECTC), IEEE 66th, 2016] propose une solution pour garantir une surface de contact constante entre les plots d'interconnexion 3D de deux puces empilées l'une sur l'autre. Cette solution, illustrée par la figure 2, consiste à adopter des matrices de plots d'interconnexion de géométries différentes. La puce supérieure 100a comprend une pluralité de plots d'interconnexion 104a de section carrée agencés en lignes et en colonnes, avec un pas de répétition (« pitch » en anglais) identique dans les deux directions, par exemple égal à 3,6 μm. Les plots d'interconnexion 104a mesurent alors 0,9 μm de côté, soit ¼ du pas de répétition. La puce inférieure 100b comprend des plots d'interconnexion 104b agencés également selon une maille carrée dont le pas de répétition est égal à 3,6 μm. Les plots d'interconnexion 104b mesurent cependant 2,7 μm de côté, soit ¾ du pas de répétition.

Dans le cas représenté sur la figure 2, celui d'un alignement parfait entre les deux puces, chaque plot d'interconnexion 104a de la puce supérieure 100a est positionné au centre d'un plot d'interconnexion 104b de la puce inférieure 100b. La surface de contact entre les plots 104a-104b est égale à la superficie du plus petit plot, 104a. Tant que le plot 104a ne dépasse pas du périmètre du plot 104b, c'est-à-dire tant que le désalignement entre les deux puces n'excède pas 0,9 μm dans la direction des lignes et/ou dans la direction des colonnes, cette surface de contact est en outre constante. Comme indiqué dans le document, une résistance de contact constante limite la dispersion des performances électriques au sein d'un même circuit 3D et entre plusieurs circuits 3D, en particulier en termes de résistance électrique.

La demande de brevet US2017/154873 décrit un autre empilement de puces électroniques qui tolère un désalignement important et garantit une surface de contact constante dans un certain intervalle de tolérance. Les plots d'interconnexion 3D sont dans cet empilement situés à la périphérie des puces.

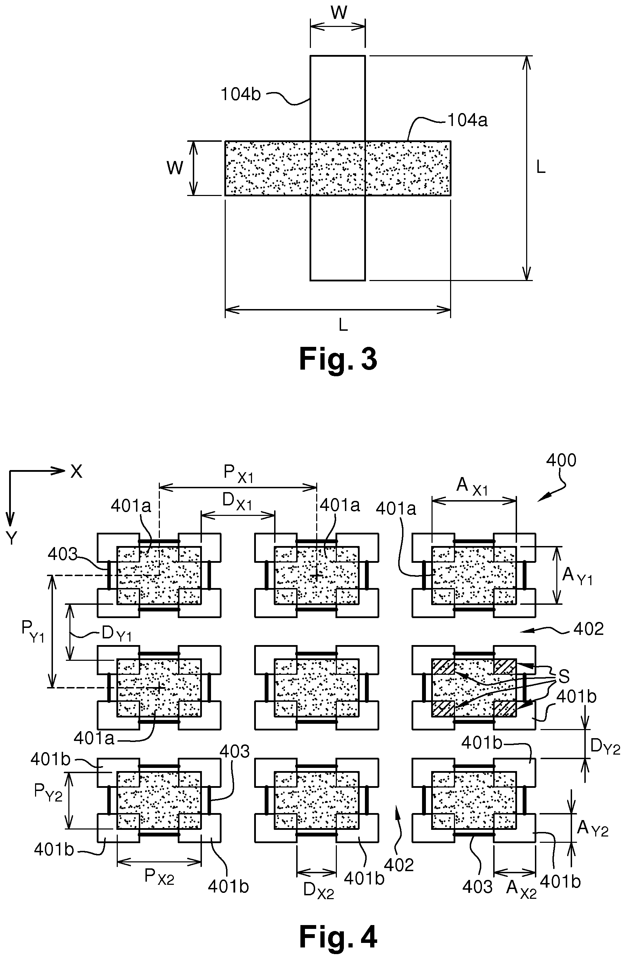

La figure 3 est une vue en coupe de l'empilement prise au niveau de l'interface de collage et limitée à deux plots d'interconnexion 3D appartenant à des puces différentes. Le plot d'interconnexion 104a de la puce supérieure et le plot d'interconnexion 104b de la puce inférieure ont des sections rectangulaires de mêmes dimensions et sont orientés perpendiculairement l'un par rapport à autre. Le rapport longueur L sur largeur W des plots 104a-104b est compris entre 2 et 4. Le désalignement maximum toléré, permettant d'obtenir une surface de contact constante, est dans chaque direction égal à ± L/2, soit un intervalle de tolérance de longueur L.

Les structures d'interconnexion 3D décrites ci-dessus rendent les performances des circuits 3D plus homogènes et améliorent leur fiabilité, mais complexifie la fabrication, en particulier l'étape de planarisation des surfaces de collage par polissage mécano-chimique (« Chemical Mechanical Planarization », CMP). En effet, le métal (cuivre) qui constitue les plots d'interconnexion n'est pas réparti de façon uniforme à la surface des puces. Dans la solution proposée par SW. Kim et al., la densité de métal, qui représente la surface des plots sur la surface totale de collage, n'est que de 6 % environ ($0,9^2/3,6^2$) pour la puce inférieure. De larges portions d'oxyde de silicium séparent donc les plots d'interconnexion 104b (cf. Fig.2). Les portions d'oxyde sont également très importantes à la surface des puces du document US2017/154873, du fait de l'orientation perpendiculaire des plots et de leur position à la périphérie des puces. Comme l'oxyde de silicium est poli plus rapidement que le métal, il est difficile d'obtenir une surface de collage plane avec de telles structures.

Le document FR 2 828 334 A1 divulgue une connexion puce-à-puce avec une pluralité de plots d'interconnexion sur une puce associés avec des plots d'interconnexion sur l'autre puce. Le document US 2008/156521 A1 divulgue une connexion puce-à-puce ou puce-à-substrat avec une pluralité de plots d'interconnexion sur une puce ou substrat associés avec des plots d'interconnexion sur l'autre puce ou substrat. Le document US 2015/008575 A1 divulgue une connexion entre une puce et un substrat avec une pluralité de plots d'interconnexion sur le substrat, les plots d'interconnexions étant combinés et connectés dans des groupes à quatre plots. Le document US 2014/252606 A1 divulgue une connexion entre une puce et un substrat avec une pluralité de plots d'interconnexion sur la puce associés avec des plots d'interconnexion sur le substrat.

**RÉSUMÉ DE L'INVENTION**

Il existe donc un besoin de prévoir un empilement de puces électroniques qui soit tolérant au désalignement, fiable, facile à réaliser et dont les performances électriques sont identiques quelle que soit la valeur du désalignement dans un intervalle de tolérance.

Selon l'invention, on tend à satisfaire ce besoin en prévoyant un empilement 3D de puces électroniques comprenant :

- une première puce présentant sur une première face une pluralité de premiers plots d'interconnexion de section rectangulaire, agencés en lignes et en colonnes, les colonnes de premiers plots d'interconnexion présentant un premier pas de répétition dans une première direction et les lignes de premiers plots d'interconnexion présentant un deuxième pas de répétition dans une deuxième direction perpendiculaire à la première direction ;

- une deuxième puce présentant, sur une deuxième face collée à la première face de la première puce, une pluralité de deuxièmes plots d'interconnexion agencés en lignes et en colonnes, les colonnes de deuxièmes plots d'interconnexion présentant un troisième pas de répétition dans la première direction et les lignes de deuxièmes plots d'interconnexion présentant un quatrième pas de répétition dans la deuxième direction, au moins une partie des deuxièmes plots d'interconnexion étant en contact avec les premiers plots d'interconnexion pour coupler électriquement les première et deuxième puces ; et dans lequel :

- les premiers plots d'interconnexion présentent une première dimension dans la première direction égale à m fois le troisième pas de répétition, où m est un entier naturel non nul, et une deuxième dimension dans la deuxième direction égale à n fois le quatrième pas de répétition, où n est un entier naturel non nul ;

- les premiers plots d'interconnexion appartenant à une même ligne et à deux colonnes consécutives sont séparés dans la première direction d'une première distance égale à q fois le troisième pas de répétition, où q est un entier naturel non nul ;

- les premiers plots d'interconnexion appartenant à une même colonne et à deux lignes consécutives sont séparés dans la deuxième direction d'une deuxième distance égale à r fois le quatrième pas de répétition, où r est un entier naturel non nul ;

- les deuxièmes plots d'interconnexion sont interconnectés en une pluralité de groupes, chaque groupe comprenant un nombre N de deuxièmes plots d'interconnexion interconnectés tel que :

$$N = (m + q)(n + r),$$

chaque groupe étant connecté électriquement à un premier plot d'interconnexion par au moins un des deuxièmes plots d'interconnexion du groupe.

Pour chacun des premiers plots d'interconnexion appartenant à la première puce, il est prévu un groupe de N (N étant nécessairement supérieur ou égal à 4) deuxièmes plots d'interconnexion régulièrement répartis à la surface de la deuxième puce et interconnectés électriquement. En multipliant ainsi le nombre de deuxièmes plots associés à chaque premier plot, une meilleure densité de métal peut être obtenue à la surface de la deuxième puce. La préparation de la deuxième puce avant son collage, et notamment l'étape de planarisation de sa surface de collage, s'en trouve facilitée.

L'agencement des premiers plots et des deuxièmes plots, sous la forme de matrices dont les dimensions sont liées entre elles (dans chaque direction, la dimension et l'espacement des premiers plots sont des multiples du pas de répétition des deuxièmes plots), garantit en outre une surface de contact entre le premier plot et le groupe de deuxièmes plots associé, tant que le désalignement entre les puces est compris dans une plage de désalignement appelée intervalle ou fenêtre de tolérance. Cette surface de contact constante permet d'obtenir des performances électriques identiques quelle que soit la valeur du désalignement (dans l'intervalle de tolérance) et une énergie de collage homogène, au sein d'une même plaque ou entre plusieurs plaques/puces. La qualité du collage - et donc la fiabilité de l'empilement - est par conséquent améliorée. Suivant le désalignement entre les puces, la surface de contact entre le premier plot et le groupe de deuxièmes plots peut s'étendre à toute la surface d'un deuxième plot du groupe ou peut être répartie sur plusieurs (jusqu'à N) deuxièmes plots du groupe.

Dans un mode de réalisation préférentiel de l'invention, la première dimension des premiers plots d'interconnexion est égale au troisième pas de répétition, la deuxième dimension des premiers plots d'interconnexion est égale au quatrième pas de répétition, la première distance est égale au troisième pas de répétition et la deuxième distance est égale au quatrième pas de répétition.

Dans une variante de réalisation, la première dimension des premiers plots d'interconnexion est égale à deux fois le troisième pas de répétition, la deuxième dimension des premiers plots d'interconnexion est égale à deux fois le quatrième pas de répétition, la première distance est égale à deux fois le troisième pas de répétition et la deuxième distance est égale à deux fois le quatrième pas de répétition.

L'empilement selon l'invention peut également présenter une ou plusieurs des caractéristiques ci-dessous, considérées individuellement ou selon toutes les combinaisons techniquement possibles.

De préférence, la première dimension des premiers plots d'interconnexion est en outre égale au premier pas de répétition divisé par 2 et la deuxième dimension des premiers plots d'interconnexion est en outre égale au deuxième pas de répétition divisé par 2. La densité de métal en surface de la première puce est alors égale à 25 %. Cette configuration correspond à une répartition homogène du métal dans chacune des première et deuxième directions.

Le premier pas de répétition est avantageusement égal au deuxième pas de répétition. La répartition du métal en surface de la première puce est alors la même dans les première et deuxième directions.

Les deuxièmes plots d'interconnexion ont par exemple une section rectangulaire, ronde ou octogonale.

De préférence, les deuxièmes plots d'interconnexion présentent une première dimension dans la première direction égale au troisième pas de répétition divisé par 2 et une deuxième dimension dans la deuxième direction égale au quatrième pas de répétition divisé par 2. La densité de métal en surface de la deuxième puce est alors égale à 25 %. Cette configuration correspond à une répartition homogène du métal dans chacune des première et deuxième directions.

Le troisième pas de répétition est avantageusement égal au quatrième pas de répétition. La répartition du métal en surface de la deuxième puce est alors la même dans les première et deuxième directions.

Selon un développement, la deuxième puce comprend une couche de composants actifs et une pluralité de niveaux d'interconnexions métalliques reliant les composants actifs, et au moins un des niveaux d'interconnexions métalliques sert à interconnecter les N deuxièmes plots d'interconnexion de chaque groupe.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- la figure 1 montre un circuit 3D intégrant un premier exemple d'empilement de puces électroniques selon l'art antérieur ;
- la figure 2 représente une structure d'interconnexion 3D employée dans un deuxième exemple d'empilement de puces électroniques selon l'art antérieur ;
- la figure 3 représente une structure d'interconnexion 3D employée dans un troisième exemple d'empilement de puces électroniques selon l'art antérieur ;
- la figure 4 représente une structure d'interconnexion 3D employée dans un empilement de puces électroniques selon un premier mode de réalisation de l'invention ;
- les figures 5A et 5B illustrent la structure d'interconnexion 3D de la figure 4 dans des situations de désalignement de valeurs différentes ;
- la figure 6 représente une structure d'interconnexion 3D employée dans un empilement de puces électroniques selon un deuxième mode de réalisation de l'invention ;
- la figure 7 représente une structure d'interconnexion 3D employée dans un empilement de puces électroniques selon un troisième mode de réalisation de l'invention ; et
- la figure 8 représente une structure d'interconnexion 3D employée dans un empilement de puces électroniques selon un quatrième mode de réalisation de l'invention.

Pour plus de clarté, les éléments identiques ou similaires sont repérés par des signes de référence identiques sur l'ensemble des figures.

## DESCRIPTION DÉTAILLÉE D'AU MOINS UN MODE DE RÉALISATION

Dans la description qui suit, on appelle « structure d'interconnexion 3D » l'ensemble des plots d'interconnexion qui permettent de relier électriquement deux puces électroniques empilées (verticalement) l'une sur l'autre. Ces plots d'interconnexion sont présents sur une face de chaque puce électronique, qui peut être la face avant ou la face arrière. La face avant d'une puce électronique désigne la face d'un substrat, généralement en un matériau semi-conducteur tel que le silicium, sur laquelle sont formés des composants actifs, par exemple des transistors, puis (le cas échéant) des composants passifs et des niveaux d'interconnexions métalliques. La face arrière de la puce électronique est la face du substrat opposée à la face avant.

Les deux puces électroniques sont collées entre elles, de préférence par une technique de collage direct (i.e. sans introduire de composé intermédiaire - tel qu'un adhésif, une cire ou un alliage à faible point de fusion - au niveau de l'interface de collage), par exemple de type métal-métal ou de type hybride métal-diélectrique. Le collage peut être réalisé selon différentes approches : face avant contre face avant, face arrière contre face arrière ou face avant contre face arrière. Les deux faces qui sont collées entre elles sont sensiblement planes, leur topologie ne dépassant généralement pas 15 nm. Il n'existe alors aucun espace entre les puces après leur collage, à la différence d'autres technologies d'assemblage (typiquement par microbilles ou micro-piliers), qui présentent une topologie importante (de l'ordre de quelques $\mu$m) et nécessitent l'introduction d'un polymère entre les puces.

La figure 4 est une vue en coupe partielle d'un empilement de puces électroniques selon un premier mode de réalisation de l'invention. Cette vue est prise au niveau d'une interface de collage entre deux puces électroniques et représente schématiquement une première structure d'interconnexion 3D 400 assurant la connexion électrique entre les deux puces électroniques.

La structure d'interconnexion 3D 400 comprend une pluralité de premiers plots d'interconnexion 401a identiques appartenant à une première puce électronique et une pluralité de deuxièmes plots d'interconnexion 401b identiques appartenant à une deuxième puce électronique. La face de la première puce, sur laquelle débouchent les premiers plots d'interconnexion 401a, est collée à la face de la deuxième puce faisant apparaître les deuxièmes plots d'interconnexion 401b. Les premiers plots d'interconnexion 401a et les deuxièmes plots d'interconnexion 401b sont de préférence en métal, par exemple en cuivre ou en aluminium, et participent au collage des première et deuxième puces.

Les deuxièmes plots d'interconnexion 401b de la deuxième puce, de même que les premiers plots d'interconnexion 401a de la première puce, sont espacés les uns des autres par des portions 402 isolantes électriquement, par exemple en oxyde de silicium. La surface de collage de chaque puce est donc composée de plots d'interconnexion métalliques entourés d'un matériau diélectrique.

Les premiers plots d'interconnexion 401a de la première puce sont distincts et agencés en lignes et en colonnes, sous la forme d'une matrice ou maille. Les colonnes de premiers plots 401a présentent un premier pas de répétition $P_{X1}$ dans une première direction X du plan de coupe de la figure 4. Ce premier pas de répétition $P_{X1}$ est égal à la distance qui sépare les centres de deux plots 401a appartenant à une même ligne et à deux colonnes consécutives. De la même façon, les lignes de premiers plots 401a présentent un deuxième pas de répétition $P_{Y1}$ dans une deuxième direction Y du plan, perpendiculaire à la première direction X. Ce deuxième pas de répétition $P_{Y1}$ est égal à la distance qui sépare les centres de deux plots 401a appartenant à une même colonne et à deux lignes consécutives. En d'autres termes, les premiers plots d'interconnexion 401a sont reproduits de façon périodique à la surface de la première puce, et ce dans les deux directions X et Y.

Les deuxièmes plots d'interconnexion 401b de la deuxième puce sont également distincts et agencés en lignes et en colonnes. Les colonnes de deuxièmes plots 401b se répètent dans la première direction X selon un troisième pas de répétition $P_{X2}$, tandis que les lignes de deuxièmes plots 401b se répètent dans la deuxième direction Y selon un quatrième pas de répétition $P_{Y2}$. Les troisième et quatrième pas de répétition PX2-PY2 sont définis de la même manière que les premier et deuxième pas de répétition $P_{X1}$-$P_{Y1}$, par rapport aux centres des deuxièmes plots 401b.

Le nombre de lignes et de colonnes, et donc de plots d'interconnexion à la surface de chaque puce, dépend de la densité d'interconnexion recherchée et de la superficie des surfaces de collage des puces. Pour ne pas alourdir inutilement la figure 4, seules trois colonnes et trois lignes de premiers plots 401a sont représentées et seules six colonnes et six lignes de deuxièmes plots 401b sont représentées.

Comme illustré sur la figure 4, le premier pas de répétition $P_{X1}$ (pas de répétition en X des premiers plots 401a) peut être différent du deuxième pas de répétition $P_{Y1}$ (pas de répétition en Y des premiers plots 401a) et le troisième pas de répétition $P_{X2}$ (pas de répétition en X des deuxièmes plots 401b) peut être différent du quatrième pas de répétition $P_{Y2}$ (pas de répétition en Y des deuxièmes plots 401b). Les premiers plots 401a et les deuxièmes plots 402b se présentent alors sous la forme de mailles rectangulaires.

Les premiers plots d'interconnexion 401a ont une section, dans le plan de la face de collage, de forme rectangulaire. Les dimensions des premiers plots 401a dans la première direction X et dans la deuxième direction Y sont notées respectivement Axi et $A_{Y1}$.

La section des deuxièmes plots d'interconnexion 401 b (dans le plan de la face de collage) peut être de forme quelconque, par exemple rectangulaire (cf. Fig.4), ronde ou octogonale. Les dimensions des deuxièmes plots 401b dans la premier direction X et dans la deuxième direction Y sont notées respectivement $A_{X2}$ et $A_{Y2}$. La distance qui sépare dans la direction X deux deuxièmes plots 401b consécutifs appartenant à une même ligne est notée $D_{X2}$ et la distance qui sépare dans la direction Y deux deuxièmes plots 401b consécutifs appartenant à une même colonne est notée $D_{Y2}$.

Dans ce premier mode de réalisation, la dimension Axi en X des premiers plots 401a est égale au troisième pas de répétition $P_{X2}$ et la dimension $A_{Y1}$ en Y des premiers plots 401a est égale au quatrième pas de répétition $P_{Y2}$. En outre, la distance $D_{X1}$ qui sépare dans la direction X deux premiers plots 401a consécutifs d'une même ligne, c'est-à-dire la largeur de la portion isolante 402 séparant deux colonnes consécutives de premiers plots 401a, est égale au troisième pas de répétition $P_{X2}$. De façon similaire, la distance $D_{Y1}$ qui sépare dans la direction Y deux premiers plots 401a consécutifs d'une même colonne, c'est-à-dire la largeur de la portion isolante 402 séparant deux lignes consécutives de premiers plots 401a, est égale au quatrième pas de répétition $P_{Y2}$.

Bien que séparés physiquement, les deuxièmes plots d'interconnexion 401b sont interconnectés par groupe de N, de préférence au moyen de pistes métalliques 403 situées dans un plan parallèle à la face de collage de la deuxième puce. Chaque groupe de deuxièmes plots d'interconnexion 401b est relié électriquement à un unique premier plot d'interconnexion 401a. Pour réaliser cette connexion électrique, au moins un deuxième plot 401b de chaque groupe est en contact direct avec le premier plot 401a associé au groupe. Le nombre N de deuxièmes plots 401b dans les groupes varie en fonction des dimensions $A_{X1}$-$A_{Y1}$ des premiers plots 401a et des espacements $D_{X1}$-$D_{Y1}$ entre les premiers plots 401a. À titre d'exemple, dans le mode de réalisation de la figure 4, chaque premier plot 401a est relié à quatre deuxièmes plots 401b interconnectés (N=4).

De préférence, la deuxième puce comprend plusieurs niveaux d'interconnexions métalliques (appartenant à un bloc fonctionnel ou ensemble de niveaux technologiques appelé « Back End Of Line » ou BEOL) reliant des composants actifs (appartenant à un bloc fonctionnel appelé « Front End Of Line » ou FEOL), par exemple des transistors. Au moins un des niveaux d'interconnexions métalliques est avantageusement utilisé pour interconnecter les N deuxièmes plots d'interconnexion de chaque groupe. Autrement dit, les pistes métalliques 403 reliant les deuxièmes plots 401b sont ajoutées à ce niveau d'interconnexions métalliques. Avantageusement, les pistes métalliques 403 sont ajoutées aux deux derniers niveaux d'interconnexions métalliques (i.e. les plus éloignés des composants actifs), dont la densité d'interconnexions est plus faible. Ces deux derniers niveaux sont habituellement utilisés pour réaliser la grille d'alimentation (« Power Delivery Network ») de la puce et la création de pistes métalliques supplémentaires 403 n'impacte pas les performances de cette grille.

Une particularité de la structure d'interconnexion 400 est que la surface de contact S entre chaque premier plot 401a et les N deuxièmes plots 401b du groupe associé est indépendante du désalignement lié au collage des première et deuxième puces, tant que ce désalignement ne dépasse pas (en X et en Y) des valeurs seuil délimitant un intervalle (ou fenêtre) de tolérance.

La configuration montrée sur la figure 4 est celle d'un alignement parfait entre les deux puces (désalignement nul en X et en Y). Chaque premier plot 401a est centré sur le groupe de deuxièmes plots 401b auquel il est connecté. La surface de contact S est répartie de manière uniforme sur les quatre deuxièmes plots 401b du groupe. Elle est égale à la superficie d'un deuxième plot 401b.

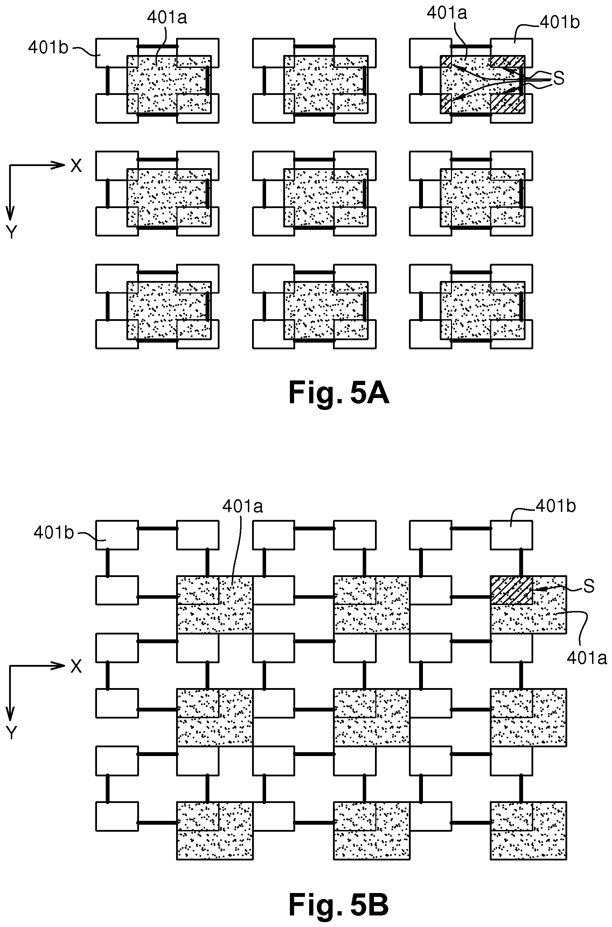

Les figures 5A et 5B montrent deux autres configurations de la structure d'interconnexion 400 (après collage des puces), dans lesquelles le désalignement entre les puces est non nul. Dans la configuration de la figure 5A, celle d'un désalignement modéré en X et en Y, la surface de contact S est répartie toujours sur les quatre plots du groupe, mais plus de façon uniforme. Toutefois, la surface de contact S est néanmoins identique à la configuration de la figure 4, car la somme des surfaces de contact de premier plot 401a à deuxième plot 401b (surfaces de contact dites individuelles) est égale à la superficie d'un deuxième plot 401b. Dans la configuration de la figure 5B, celle d'un désalignement extrême en X et en Y (en limite des intervalles de tolérance), le contact entre le premier plot 401a et le groupe de deuxièmes plots 401b ne se limite plus qu'à un seul deuxième plot 401b, sur toute sa superficie. La surface de contact S est donc toujours la même.

Cette surface de contact constante, quelle que soit la valeur du désalignement (dans l'intervalle de tolérance) entre les deux puces, permet d'homogénéiser les performances électriques d'un empilement 3D à l'autre, notamment leur résistance électrique. Ceci est valable quelle que soit la technique de report employée : puce à puce, puce à plaque ou plaque à plaque (le désalignement entre les puces peut varier d'un endroit à l'autre des plaques, notamment entre le centre et le bord des plaques).

Une surface de contact constante implique également une énergie de collage identique entre les différents empilements, ce qui est particulièrement bénéfique dans le cas des techniques de report puce à plaque et plaque à plaque car il faut ensuite procéder au découpage des empilements. La fiabilité des circuits 3D d'un point de vue mécanique est donc globalement améliorée.

Enfin, on constate que la répartition du métal à la surface de la deuxième puce (deuxièmes plots d'interconnexion 401b) est bien meilleure dans la structure d'interconnexion 400 que celle obtenue (pour la puce supérieure) dans la structure d'interconnexion de l'art antérieur (cf. Fig.2, plots d'interconnexion 104a). Ceci est dû au fait chaque premier plot 401a est associé dans la structure d'interconnexion 400 à une multitude (au moins 4) de deuxièmes plots 401b, au lieu d'un seul dans l'art antérieur. Grâce à cette meilleure répartition du métal, la fabrication de la deuxième puce (avant collage) est facilitée, en particulier l'étape d'aplanissement de sa face de collage par polissage mécano-chimique.

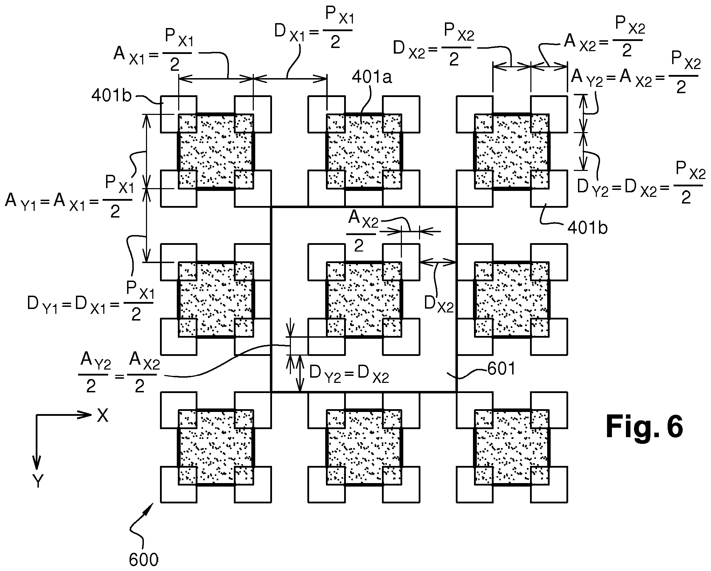

La figure 6 représente schématiquement une deuxième structure d'interconnexion 3D 600 appartenant à un empilement de puces selon un deuxième mode de réalisation de l'invention.

La deuxième structure d'interconnexion 600 représente un cas particulier de la première structure d'interconnexion 400, car les premiers et deuxièmes plots d'interconnexion 401a-401b ont une section de forme carrée. Par conséquent, la dimension $A_{X1}$ en X des premiers plots 401a est égale à la dimension $A_{Y1}$ en Y des premiers plots 401a et la dimension $A_{X2}$ en X des deuxièmes plots 401b est égale à la dimension $A_{Y2}$ en Y des deuxièmes plots 401b.

Comme dans la structure 400 de la figure 4, la dimension $A_{X1}$ en X des premiers plots 401a est avantageusement égale au premier pas de répétition $P_{X1}$ divisé par deux et la dimension $A_{Y1}$ en Y des premiers plots 401a est avantageusement égale au deuxième pas de répétition $P_{Y1}$ divisé par deux. La densité de métal di de la première puce, qui représente la surface des premiers plots 401a sur la surface totale de collage, est alors égale à 25 % :

$$d_1 = \frac{A_{X1} \times A_{Y1}}{P_{X1} \times P_{Y1}} = \frac{P_{X1}/2 \times P_{Y1}/2}{P_{X1} \times P_{Y1}} = 0,25$$

Une densité de métal di de 25 % représente une solution optimale pour faciliter la préparation de première puce, et plus particulièrement l'étape de polissage mécano-chimique de sa face de collage, car les portions de métal (plots 401a) en X et en Y sont de même largeur que les portions de diélectrique (402).

Il découle de ces considérations géométriques que le premier pas de répétition $P_{X1}$ est égal au deuxième pas de répétition $P_{Y1}$ (la maille de premiers plots 401a est donc elle-même carrée). La répartition du métal est alors la même dans la direction des lignes (X) et dans la direction des colonnes (Y).

De la même façon avantageuse, la dimension $A_{X2}$ en X des deuxièmes plots 401b et la dimension $A_{Y2}$ en Y des deuxièmes plots 401b sont égales respectivement au troisième pas de répétition $P_{X2}$ divisé par deux et au quatrième pas de répétition $P_{Y2}$ divisé par deux. La densité de métal $d_2$ en surface de la deuxième puce est alors elle aussi égale à 25 % :

$$d_2 = \frac{A_{X2} \times A_{Y2}}{P_{X2} \times P_{Y2}} = \frac{P_{X2}/2 \times P_{Y2}/2}{P_{X2} \times P_{Y2}} = 0,25$$

Les avantages en termes de fabrication décrits pour la première puce sont donc également valables pour la deuxième puce. À titre de comparaison, la densité de métal de l'une des deux puces (la puce supérieure) dans la structure d'interconnexion de l'art antérieur (cf. Fig.2) n'est que de 6 % environ.

De par ces choix géométriques, le troisième pas de répétition $P_{X2}$ est égal au quatrième pas de répétition $P_{Y2}$ (la maille de deuxièmes plots d'interconnexion 401b est donc elle aussi carrée).

Le désalignement maximum autorisé en X, noté ci-après Fx, dans la structure d'interconnexion 600 est égal à la moitié de la dimension $A_{X2}$ des deuxièmes plots 401b plus la distance $D_{X2}$ entre deux deuxièmes plots 401b consécutifs. En effet, un premier plot 401a ne doit pas entrer en contact avec les deuxièmes plots 401b des groupes adjacents. Le désalignement maximum autorisé en X est donc ici égal à ¾ du troisième pas de répétition Px2 (car Ax2 = Dx2 = Px2/2) ou encore 3/8 du premier pas de répétition $P_{X1}$ (car $P_{X1} = A_{X1} + D_{X1} = 2*P_{X2}$) :

$$F_X = \pm \left( \frac{A_{X2}}{2} + D_{X2} \right) = \pm \frac{3}{4} P_{X2} = \pm \frac{3}{8} P_{X1}$$

La fenêtre de tolérance, représentée par la zone 601 sur la figure 6, présente donc une longueur en X égale à 75 % du premier pas de répétition $P_{X1}$.

Le désalignement maximum autorisé en Y (noté $F_Y$) est identique à celui autorisé en X (car les distances, dimensions et pas de répétition en Y sont les mêmes qu'en X), soit une fenêtre de tolérance de largeur en Y égale à 75 % du premier pas de répétition $P_{X1}$.

À titre de comparaison, dans la structure d'interconnexion de l'art antérieur (Fig.2), la fenêtre de tolérance n'est que de 50 % du pas de répétition (2*0,9 $\mu$m/3,6 $\mu$m = 0,5), en X et en Y.

Pour un même (premier) pas de répétition (c'est-à-dire une même densité d'interconnexion 3D « fonctionnelles »), la structure d'interconnexion 600 selon l'invention tolère donc un désalignement plus important que la structure d'interconnexion de l'art antérieur.

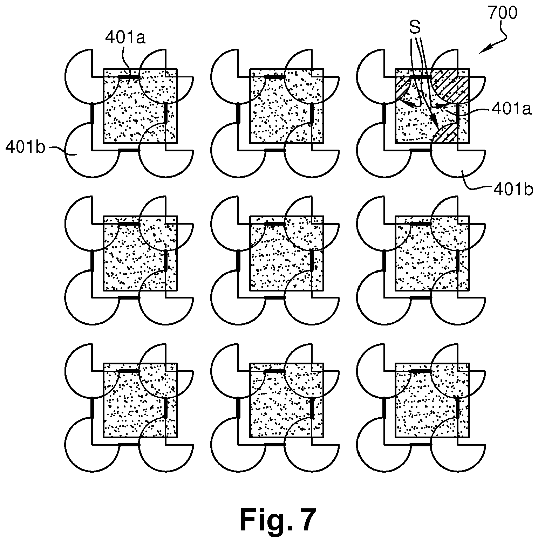

La figure 7 représente schématiquement une troisième structure d'interconnexion 3D 700 appartenant à un empilement de puces selon un troisième mode de réalisation de l'invention.

La troisième structure d'interconnexion 700 diffère de la deuxième structure d'interconnexion 600 uniquement dans la forme des deuxièmes plots d'interconnexion 401b. La section des deuxièmes plots 401b n'est en effet pas limitée à une forme rectangulaire (Fig.4) ou carrée (Fig.6). Une surface de contact S constante (quel que soit le désalignement dans l'intervalle de tolérance) est en effet obtenue même si la section des deuxièmes plots 401b n'est pas symétrique en X et en Y. Dans le mode de réalisation de la figure 7, la surface de contact S est encore égale à la superficie d'un deuxième plot 401b.

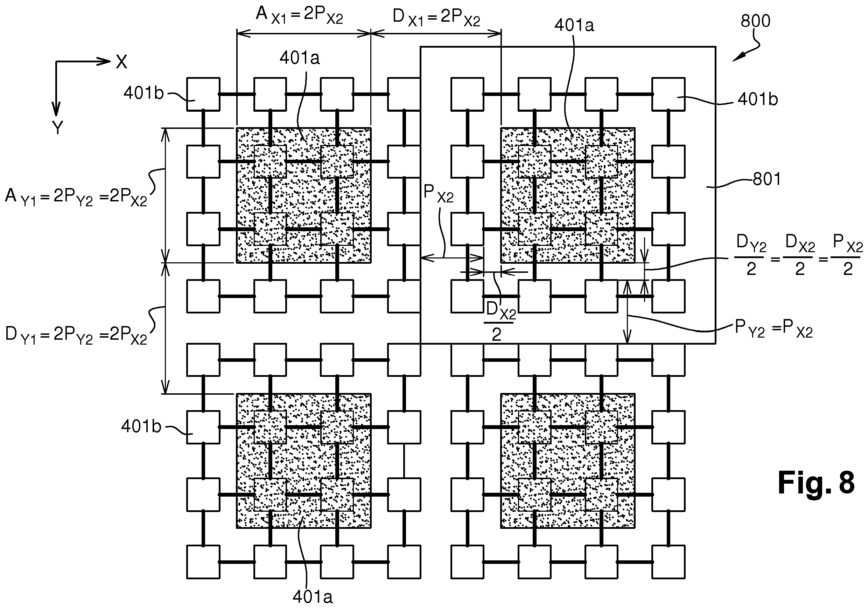

Dans une quatrième structure d'interconnexion 800 représentée par la figure 8, les premiers et deuxièmes plots 401a-401b sont de section carrée et organisés selon des mailles également carrées. Le premier pas de répétition $P_{X1}$ est donc égal au deuxième pas de répétition $P_{Y1}$ et le troisième pas de répétition $P_{X2}$ est égal au quatrième pas de répétition $P_{Y2}$. Les dimensions Axi (en X) et $A_{Y1}$ (en Y) des premiers plots 401a, ainsi que les distances $D_{X1}$ (en X) et $D_{Y1}$ (en Y) qui séparent les premiers plots 401a, sont en outre égales à deux fois le troisième (ou quatrième) pas de répétition $P_{X2}$ (= $P_{Y2}$). Les dimensions $A_{X2}$ (en X) et $A_{Y2}$ (en Y) des deuxièmes plots 401b sont égales au troisième pas de répétition $P_{X2}$ divisé par 2. Les densités $d_1$ et $d_2$ de métal sont par conséquent toujours égale à 25 %. Le nombre N de deuxièmes plots interconnectés dans chaque groupe est égal à 16 (ils sont répartis selon une matrice 4x4). La surface de contact S est constante et égale à la superficie de quatre deuxièmes plots 401b, quelle que soit la valeur du désalignement dans l'intervalle de tolérance.

Les désalignements maximum autorisés en X ($F_X$) et en Y ($F_Y$) sont égaux à une fois le troisième pas de répétition $P_{X2}$ plus la moitié de la distance $D_{X2}$ entre deux deuxièmes plots 401b consécutifs, soit ici 5/4 du troisième pas de répétition $P_{X2}$ ou encore 5/16 du premier pas de répétition $P_{X1}$ (car $P_{X1} = A_{X1} + D_{X1} = 4*P_{X2}$) :

$$F_X = F_Y = \pm \left( \frac{D_{X2}}{2} + P_{X2} \right) = \pm \frac{5}{4} P_{X2} == \pm \frac{5}{16} P_{X1}$$

La fenêtre de tolérance, représentée par la zone 801 sur la figure 8, présente donc une longueur en X et une largeur en Y égale à 62,5 % du premier pas de répétition $P_{X1}$. La fenêtre de tolérance de la quatrième structure d'interconnexion 800 est donc moins étendue que celle de la deuxième structure d'interconnexion 600 ($F_X = F_Y = 75$ %) mais toujours plus étendue que la fenêtre de tolérance de la structure d'interconnexion selon l'art antérieur.

De façon plus générale, une surface de contact S constante peut être obtenue avec une structure d'interconnexion de type de la figure 4 dès lors qu'elle remplit les critères suivants :

- la dimension Axi en X des premiers plots 401a est égale à m fois le troisième pas de répétition $P_{X2}$, où m est un premier entier naturel non nul ;
- la dimension $A_{Y1}$ en Y des premiers plots 401a est égale à *n* fois le quatrième pas de répétition $P_{Y2}$, où *n* est un deuxième entier naturel non nul ;
- la distance $D_{X1}$ qui sépare dans la direction X deux premiers plots 401a consécutifs (d'une même ligne) est égale à *q* fois le troisième pas de répétition $P_{X2}$, où *q* est un troisième entier naturel non nul ;
- la distance $D_{Y1}$ qui sépare dans la direction Y deux premiers plots 401a consécutifs est égale à *r* fois le quatrième pas de répétition $P_{Y2}$, où *r* est un quatrième entier naturel non nul.

Les entiers naturels *m, n, q* et *r* peuvent être égaux ou différents les uns des autres.

Le nombre N de deuxièmes plots d'interconnexion 401 b interconnectés dans chaque groupe satisfait à l'équation suivante :

$$N = (m + q)(n + r)$$

La surface de contact S entre chaque premier plot 401a et les N deuxièmes plots 401b du groupe associé est donnée par la formule suivante :

$$S = 4 \times \left( \frac{S_{plot}}{4} \right) + 2 \times (m-1) \left( \frac{S_{plot}}{2} \right) + 2 \times (n-1) \left( \frac{S_{plot}}{2} \right)$$
$$+ (m-1)(n-1) \times S_{plot} = m \times n \times S_{plot}$$

avec $S_{plot}$ la superficie d'un deuxième plot d'interconnexion 401b.

Dans le premier mode de réalisation (Fig.4), le deuxième mode de réalisation (Fig.6) et le troisième mode de réalisation (Fig.7), les entiers naturels *m, n, q* et *r* valent tous 1 ($A_{X1} = P_{X2}$, $A_{Y1} = P_{Y2}$, $D_{X1} = Px2$ et $D_{Y1} = P_{Y2}$). Comme indiqué précédent, le nombre N de deuxièmes plots 401b dans chaque groupe est égal à 4 (N = 4) et la surface de contact S est égale à la superficie $S_{plot}$ d'un deuxième plot d'interconnexion 401b (S = $S_{plot}$).

Dans le quatrième mode de réalisation (Fig.8), les entiers naturels *m*, *n, q* et *r* valent tous 2 ($A_{X1}$ = 2*$P_{X2}$, $A_{Y1}$ = 2*$P_{Y2}$, $D_{X1}$ = 2*$P_{X2}$ et $D_{Y1}$ = 2*$P_{Y2}$). Le nombre N de deuxièmes plots 401b dans chaque groupe est égal à 16 (N = 16), la surface de contact S est égale à la superficie de quatre deuxièmes plots 401b (S = 4*$S_{plot}$).

Les structures d'interconnexion 400, 600, 700 et 800 décrites ci-dessous tolèrent, outre un désalignement lié au collage des puces (et représenté par les figures 5A-5B), un décalage des plots d'interconnexion au sein même d'une puce. Autrement dit, la surface de contact S entre un premier plot 401a et un groupe de deuxièmes plots 401b reste constante même si la distance entre les plots 401a ou 401b varie légèrement au sein de la matrice. Ce décalage est variable en fonction de la position sur la plaquette (faible entre deux plots voisins, mais peut être important entre deux plots éloignés sur la plaquette). Il est par exemple dû à une dilatation des matériaux ou à des désalignements lors des étapes de fabrication des puces (étapes de photolithographie notamment). Les performances électriques des interconnexions 3D, et notamment leur résistance électrique, sont donc homogènes au sein d'un même empilement. Pour la même raison, l'énergie de collage est homogène au sein d'un même empilement, ce qui améliore la résistance mécanique et la fiabilité de l'empilement.

Ces structures d'interconnexion sont utilisables quelle que soit la valeur du pas de répétition des premiers plots 401a, appelé pas de répétition « fonctionnel » car il fixe la densité des interconnexions 3D dans l'empilement. Elles s'avèrent cependant particulièrement avantageuses pour un pas de répétition fonctionnel inférieur à 2 μm. En effet, avec un tel pas de répétition, les plots d'interconnexion 3D et les lignes métalliques des niveaux d'interconnexions supérieurs ont des dimensions très proches. L'intérêt d'avoir une surface de contact S constante, et donc une résistante électrique homogène, est donc très fort. À l'inverse, lorsque le pas de répétition fonctionnel est de l'ordre de 4-5 μm ou plus, les plots d'interconnexion 3D sont plus gros et la résistance des lignes métalliques est grande devant celle des plots d'interconnexion 3D. La variation de la surface de contact S influe alors dans une moindre mesure sur les performances électriques globales des interconnexions qui relient les composants actifs des deux puces (interconnexions 3D, lignes métalliques des niveaux d'interconnexions et vias entre les niveaux).

Les caractéristiques des structures d'interconnexion 400, 600, 700 et 800, décrites au travers des figures 4, 6 à 8, peuvent être aisément combinées entre elles. Il est notamment possible de combiner les caractéristiques relatives à la forme des deuxièmes plots 401b, aux pas de répétition en X et en Y des plots 401a-401b et aux dimensions des plots 401a-401b par rapport aux pas de répétition, pour définir de nouvelles structures d'interconnexion 3D bénéficiant des mêmes avantages.

L'empilement de puces électroniques selon l'invention comprend au moins les première et deuxième puces électroniques. La première puce munie des premiers plots d'interconnexion 401a peut être disposée sur la deuxième puce munie des deuxièmes plots d'interconnexion 401b, ou inversement. Un empilement de plus de deux puces électroniques comprend plus d'une structure d'interconnexion 3D et au moins une des puces électroniques présente des plots d'interconnexion sur ses deux faces (face avant et face arrière).

## Revendications

1. Empilement 3D de puces électroniques comprenant :

   - une première puce présentant sur une première face une pluralité de premiers plots d'interconnexion (401a) de section rectangulaire, agencés en lignes et en colonnes, les colonnes de premiers plots d'interconnexion présentant un premier pas de répétition ($P_{X1}$) dans une première direction (X) et les lignes de premiers plots d'interconnexion présentant un deuxième pas de répétition ($P_{Y1}$) dans une deuxième direction (Y) perpendiculaire à la première direction ;
   - une deuxième puce présentant, sur une deuxième face collée à la première face de la première puce, une pluralité de deuxièmes plots d'interconnexion (401b) agencés en lignes et en colonnes, les colonnes de deuxièmes plots d'interconnexion présentant un troisième pas de répétition ($P_{X2}$) dans la première direction (X) et les lignes de deuxièmes plots d'interconnexion présentant un quatrième pas de répétition ($P_{Y2}$) dans la deuxième direction (Y), au moins une partie des deuxièmes plots d'interconnexion (401b) étant en contact avec les premiers plots d'interconnexion (401a) pour coupler électriquement les première et deuxième puces ;

   et dans lequel

   - les premiers plots d'interconnexion (401a) présentent une première dimension ($A_{X1}$) dans la première direction (X) égale à m fois le troisième pas de répétition ($P_{X2}$), où m est un entier naturel non nul, et une deuxième dimension ($A_{Y1}$) dans la deuxième direction (Y) égale à *n* fois le quatrième pas de répétition ($P_{Y2}$), où *n* est un entier naturel non nul ;

- les premiers plots d'interconnexion appartenant à une même ligne et à deux colonnes consécutives sont séparés dans la première direction (X) d'une première distance ($D_{X1}$) égale à $q$ fois le troisième pas de répétition ($P_{X2}$), où $q$ est un entier naturel non nul ;

- les premiers plots d'interconnexion appartenant à une même colonne et à deux lignes consécutives sont séparés dans la deuxième direction (Y) d'une deuxième distance ($D_{Y1}$) égale à $r$ fois le quatrième pas de répétition ($P_{Y2}$), où $r$ est un entier naturel non nul ;

- les deuxièmes plots d'interconnexion (401b) sont interconnectés en une pluralité de groupes, chaque groupe comprenant un nombre N de deuxièmes plots d'interconnexion (401b) interconnectés tel que :

$$N = (m + q)(n + r),$$

chaque groupe étant connecté électriquement à un premier plot d'interconnexion (401a) par au moins un des deuxièmes plots d'interconnexion (401b) du groupe.

2. Empilement selon la revendication 1, dans lequel la première dimension ($A_{X1}$) des premiers plots d'interconnexion (401a) est en outre égale au premier pas de répétition ($P_{X1}$) divisé par 2 et dans lequel la deuxième dimension ($A_{Y1}$) des premiers plots d'interconnexion est en outre égale au deuxième pas de répétition ($P_{Y1}$) divisé par 2.

3. Empilement selon la revendication 2, dans lequel le premier pas de répétition ($P_{X1}$) est égal au deuxième pas de répétition ($P_{Y1}$).

4. Empilement selon l'une quelconque des revendications 1 à 3, dans lequel les deuxièmes plots d'interconnexion (401b) ont une section rectangulaire, ronde ou octogonale.

5. Empilement selon l'une quelconque des revendications 1 à 4, dans lequel les deuxièmes plots d'interconnexion (401b) présentent une première dimension ($A_{X2}$) dans la première direction (X) égale au troisième pas de répétition ($P_{X2}$) divisé par 2 et une deuxième dimension ($A_{Y2}$) dans la deuxième direction (Y) égale au quatrième pas de répétition ($P_{Y2}$) divisé par 2.

6. Empilement selon la revendication 5, dans lequel le troisième pas de répétition (Px2) est égal au quatrième pas de répétition ($P_{Y2}$).

7. Empilement selon l'une quelconque des revendications 1 à 6, dans lequel :

- la première dimension ($A_{X1}$) des premiers plots d'interconnexion (401a) est égale au troisième pas de répétition ($P_{X2}$) ;
- la deuxième dimension ($A_{Y1}$) des premiers plots d'interconnexion est égale au quatrième pas de répétition ($P_{Y2}$) ;
- la première distance ($D_{X1}$) est égale au troisième pas de répétition ($P_{X2}$) ; et
- la deuxième distance ($D_{Y1}$) est égale au quatrième pas de répétition ($P_{Y2}$).

8. Empilement selon l'une quelconque des revendications 1 à 6, dans lequel :

- la première dimension ($A_{X1}$) des premiers plots d'interconnexion (401a) est égale à deux fois le troisième pas de répétition ($P_{X2}$) ;
- la deuxième dimension ($A_{Y1}$) des premiers plots d'interconnexion est égale à deux fois le quatrième pas de répétition ($P_{Y2}$) ;
- la première distance ($D_{X1}$) est égale à deux fois le troisième pas de répétition ($P_{X2}$) ; et
- la deuxième distance ($D_{Y1}$) est égale à deux fois le quatrième pas de répétition ($P_{Y2}$).

9. Empilement selon l'une quelconque des revendications 1 à 8, dans lequel la deuxième puce comprend une couche de composants actifs et une pluralité de niveaux d'interconnexions métalliques reliant les composants actifs, et dans lequel au moins un des niveaux d'interconnexions métalliques sert à interconnecter les N deuxièmes plots d'interconnexion (401b) de chaque groupe.

**Patentansprüche**

1. 3D-Stapelung von elektronischen Chips, umfassend:

   - einen ersten Chip, der auf einer ersten Seite eine Vielzahl von ersten Zusammenschalt-Klötzen (410a) mit rechteckigem Querschnitt aufweist, die in Reihen und in Spalten angeordnet sind, wobei die Spalten von ersten Zusammenschalt-Klötzen einen ersten Wiederholungsschritt ($P_{x1}$) in einer ersten Richtung (X) aufweisen und die Reihen aus ersten Zusammenschalt-Klötzen einen zweiten Wiederholungsschritt ($P_{y1}$) in einer zweiten Richtung (Y) aufweisen, die lotrecht zur ersten Richtung ist;
   - einen zweiten Chip, der auf einer zweiten Seite, die mit der ersten Seite des ersten Chips verklebten ist, eine Vielzahl von zweiten Zusammenschalt-Klötzen (401b) aufweist, die in Reihen und in Spalten angeordnet sind, wobei die Spalten aus zweiten Zusammenschalt-Klötzen einen dritten Wiederholungsschritt ($P_{x2}$) in der ersten Richtung (X) aufweisen und die Reihen von zweiten Zusammenschalt-Klötzen einen vierten Wiederholungsschritt ($P_{y2}$) in der zweiten Richtung (Y) aufweisen, wobei wenigstens ein Teil der zweiten Zusammenschalt-Klötze (401b) mit den ersten Zusammenschalt-Klötzen (401a) in Kontakt ist, um den ersten und den zweiten Chip elektrisch zu koppeln;

   und in der:

   - die ersten Zusammenschalt-Klötze (401a) eine erste Abmessung ($A_{x1}$) in der ersten Richtung (X) gleich m Mal den dritten Wiederholungsschritt ($P_{x2}$) aufweisen, in der m eine ganze natürliche Zahl ungleich null ist, und eine zweite Abmessung ($A_{y1}$) in der zweiten Richtung (Y) gleich n Mal den vierten Wiederholungsschritt ($P_{y2}$), in der n eine ganze natürliche Zahl ungleich null ist;
   - die ersten Zusammenschalt-Klötze, die zu einer und derselben Reihe und zu zwei konsekutiven Spalten gehören, in der ersten Richtung (X) um eine erste Entfernung ($D_{x1}$) gleich q Mal den dritten Wiederholungsschritt ($P_{x2}$) getrennt sind, in der q eine ganze natürliche Zahl ungleich null ist;
   - die ersten Zusammenschalt-Klötze, die zu einer und derselben Spalte und zu zwei konsekutiven Reihen gehören, in der zweiten Richtung (Y) um eine zweite Entfernung ($D_{y1}$) gleich r Mal den vierten Wiederholungsschritt ($P_{y2}$) getrennt sind, in der r eine ganze natürliche Zahl ungleich null ist;
   - die zweiten Zusammenschalt-Klötze (401b) in einer Vielzahl von Gruppen zusammengeschaltet sind, wobei jede Gruppe eine Anzahl N von zweiten Zusammenschalt-Klötzen (401b) umfasst, die derart zusammenge-schaltet sind, dass:

$$N = (m + q)(n + r)$$

   jede Gruppe elektrisch durch wenigstens einen der zwei Zusammenschalt-Klötze (401b) der Gruppe an einen ersten Zusammenschalt-Klotz (401a) angeschlossen ist.

2. Stapelung gemäß Anspruch 1, bei der die erste Abmessung ($A_{x1}$) der ersten Zusammenschalt-Klötze (401a) darüber hinaus gleich dem ersten Wiederholungsschritt ($P_{x1}$), geteilt durch 2 ist und bei der die zweite Abmessung ($A_{y1}$) der ersten Zusammenschalt-Klötze darüber hinaus gleich dem zweiten Wiederholungsschritt ($P_{y1}$), geteilt durch 2 ist.

3. Stapelung gemäß Anspruch 2, bei der der erste Wiederholungsschritt ($P_{x1}$) gleich dem zweiten Wiederholungsschritt ($P_{y1}$) ist.

4. Stapelung gemäß irgendeinem der Ansprüche 1 bis 3, bei der die zweiten Zusammenschalt-Klötze (401b) einen rechteckigen, runden oder achteckigen Querschnitt aufweisen.

5. Stapelung gemäß irgendeinem der Ansprüche 1 bis 4, bei der die zweiten Zusammenschalt-Klötze (401b) eine erste Abmessung ($A_{x2}$) in der ersten Richtung (X) gleich dem dritten Wiederholungsschritt ($P_{x2}$), geteilt durch 2 und eine zweite Abmessung ($A_{x2}$) in der zweiten Richtung (Y) gleich dem vierten Wiederholungsschritt ($P_{y2}$), geteilt durch 2 aufweisen.

6. Stapelung gemäß Anspruch 5, bei der der dritte Wiederholungsschritt ($P_{x2}$) gleich dem vierten Wiederholungsschritt ($P_{y2}$) ist.

**7.** Stapelung gemäß irgendeinem der Ansprüche 1 bis 6, bei der:

- die erste Abmessung ($A_{x1}$) der ersten Zusammenschalt-Klötze (401a) gleich dem dritten Wiederholungsschritt ($P_{x2}$) ist;
- die zweite Abmessung ($A_{y1}$) der ersten Zusammenschalt-Klötze gleich dem vierten Wiederholungschritt ($P_{y2}$) ist;
- die erste Entfernung ($D_{x1}$) gleich dem dritten Wiederholungsschritt ($P_{x2}$) ist; und
- die zweite Entfernung ($D_{y1}$) gleich dem vierten Wiederholungsschritt ($P_{y2}$) ist.

**8.** Stapelung gemäß irgendeinem der Ansprüche 1 bis 6, bei der:

- die erste Abmessung ($A_{x1}$) der ersten Zusammenschalt-Klötze (401a) gleich dem Zweifachen des dritten Wiederholungsschritts ($P_{x2}$) ist;
- die zweite Abmessung ($A_{y1}$) der ersten Zusammenschalt-Klötze gleich dem Zweifachen des vierten Wiederholungsschritts ($P_{y2}$) ist;
- die erste Entfernung ($D_{x1}$) gleich dem Zweifachen des dritten Wiederholungsschritts ($P_{x2}$) ist; und
- die zweite Entfernung ($D_{y1}$) gleich dem Zweifachen des vierten Wiederholungsschritts ($P_{y2}$) ist.

**9.** Stapelung gemäß irgendeinem der Ansprüche 1 bis 8, bei der der zweite Chip eine Schicht aus aktiven Bestandteilen und eine Vielzahl von metallischen Zusammenschalt-Niveaus umfasst, die die aktiven Bestandteile verbinden, und bei der wenigstens eines der metallischen Zusammenschalt-Niveaus zum Zusammenschalten der N zweiten Zusammenschalt-Klötze (401b) jeder Gruppe dient.

**Claims**

**1.** 3D stack of electronic chips comprising:

- a first chip having on a first face a plurality of first interconnection pads (401a) of rectangular section, arranged in lines and in columns, the columns of first interconnection pads having a first pitch ($P_{X1}$) in a first direction (X) and the lines of first interconnection pads having a second pitch ($P_{Y1}$) in a second direction (Y) perpendicular to the first direction;
- a second chip having, on a second face bonded to the first face of the first chip, a plurality of second interconnection pads (401b) arranged in lines and in columns, the columns of second interconnection pads having a third pitch ($P_{X2}$) in the first direction (X) and the lines of second interconnection pads having a fourth pitch ($P_{Y2}$) in the second direction (Y), at least one part of the second interconnection pads (401b) being in contact with the first interconnection pads (401a) to electrically couple the first and second chips;

and wherein:

- the first interconnection pads (401a) have a first dimension ($A_{X1}$) in the first direction (X) equal to *m* times the third pitch ($P_{X2}$), where *m* is a non-zero natural integer, and a second dimension ($A_{Y1}$) in the second direction (Y) equal to *n* times the fourth pitch ($P_{Y2}$), where *n* is a non-zero natural integer;
- the first interconnection pads belonging to a same line and to two consecutive columns are separated in the first direction (X) by a first distance ($D_{X1}$) equal to *q* times the third pitch ($P_{X2}$), where *q* is a non-zero natural integer;
- the first interconnection pads belonging to a same column and to two consecutive lines are separated in the second direction (Y) by a second distance ($D_{Y1}$) equal to *r* times the fourth pitch ($P_{Y2}$), where *r* is a non-zero natural integer;
- the second interconnection pads (401b) are interconnected in a plurality of groups, each group comprising a number N of interconnected second interconnection pads (401b) such that:

$$N = (m + q)(n + r),$$

each group being electrically connected to a first interconnection pad (401a) by at least one of the second interconnection pads (401b) of the group.

2. Stack according to claim 1, wherein the first dimension ($A_{X1}$) of the first interconnection pads (401a) is further equal to the first pitch ($P_{X1}$) divided by 2 and wherein the second dimension ($A_{Y1}$) of the first interconnection pads is further equal to the second pitch ($P_{Y1}$) divided by 2.

3. Stack according to claim 2, wherein the first pitch ($P_{X1}$) is equal to the second pitch ($P_{Y1}$).

4. Stack according to any of claims 1 to 3, wherein the second interconnection pads (401b) have a rectangular, round or octagonal section.

5. Stack according to any of claims 1 to 4, wherein the second interconnection pads (401b) have a first dimension ($A_{X2}$) in the first direction (X) equal to the third pitch ($P_{X2}$) divided by 2 and a second dimension ($A_{Y2}$) in the second direction (Y) equal to the fourth pitch ($P_{Y2}$) divided by 2.

6. Stack according to claim 5, wherein the third pitch ($P_{X2}$) is equal to the fourth pitch ($P_{Y2}$).

7. Stack according to any of claims 1 to 6, wherein:

- the first dimension ($A_{X1}$) of the first interconnection pads (401a) is equal to the third pitch ($P_{X2}$);
- the second dimension ($A_{Y1}$) of the first interconnection pads is equal to the fourth pitch ($P_{Y2}$);
- the first distance ($D_{X1}$) is equal to the third pitch ($Px2$); and
- the second distance ($D_{Y1}$) is equal to the fourth pitch ($P_{Y2}$).

8. Stack according to any of claims 1 to 6, wherein:

- the first dimension ($A_{X1}$) of the first interconnection pads (401a) is equal to two times the third pitch ($P_{X2}$);
- the second dimension ($A_{Y1}$) of the first interconnection pads is equal to two times the fourth pitch ($P_{Y2}$);
- the first distance ($D_{X1}$) is equal to two times the third pitch ($P_{X2}$); and
- the second distance ($D_{Y1}$) is equal to two times the fourth pitch ($P_{Y2}$).

9. Stack according to any of claims 1 to 8, wherein the second chip comprises a layer of active components and a plurality of metal interconnection levels connecting the active components, and wherein at least one of the metal interconnection levels serves to interconnect the N second interconnection pads (401b) of each group.

**Fig. 1**

**Fig. 2**

**Fig. 3**

**Fig. 4**

**Fig. 5A**

**Fig. 5B**

**Fig. 6**

**Fig. 7**

Fig. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2017154873 A
- FR 2828334 A1
- US 2008156521 A1
- US 2015008575 A1
- US 2014252606 A1

**Littérature non-brevet citée dans la description**

- Ultra-fine Pitch 3D Intégration Using Face-to-Face Hybrid Wafer Bonding Combined with a Via-Middle Through-Silicon-Via Process. **SW. KIM et al.** Electronic Components and Technology Conférence (ECTC). IEEE, 2016